# EUROPÄISCHE PATENTSCHRIFT

(11) **EP 0 620 525 B1**
(45) Veröffentlichungstag und Bekanntmachung des Hinweises auf die Patenterteilung: **01.10.1997**
(21) Anmeldenummer: 94105283.9
(22) Anmeldetag: 05.04.1994
(51) Int. Cl.: G06F 11/26, G01R 31/04

(54) **EIB-Modul**
EIB-module
Module EIB

(30) Priorität: 10.04.1993 DE 4311883
(43) Veröffentlichungstag der Anmeldung: 19.10.1994
(73) Patentinhaber: Tehalit GmbH, D-67716 Heltersberg (DE)
(72) Erfinder: Pollak,Gottfried,Dipl.-Ing.FH,, D-67714 Waldfischbach-Burgalben (DE); Scherer,Peter,Dipl.-Ing.FH, D-66287 Quierscheid (DE)
(74) Vertreter: Patentanwälte Möll und Bitterich

(56) Entgegenhaltungen:
- FR-A- 2 308 106
- IBM TECHNICAL DISCLOSURE BULLETIN Bd. 19, Nr. 5 , Oktober 1976 , NEW YORK US Seiten 1740 - 1741 CHECKLEY ET AL 'loop continuity and relay tester'
- PATENT ABSTRACTS OF JAPAN vol. 9, no. 257 (P-396)(1980) 15. Oktober 1985 & JP-A-60 105 057 (FUJITSU K.K.) 10. Juni 1985

## Beschreibung

Die Erfindung betrifft EIB-Module, bestehend aus einem universellen Bus-Ankoppler und einem aufgabenspezifischen Endgerät mit Eingangs- und/oder Ausgangskanälen gemäß dem Oberbegriff der Ansprüche 1 bzw. 2.

In der Gebäudeinstallationstechnik gewinnt der European Installation Bus (EIBus), wie er von der European Installation Bus Association (EIBA) definiert ist, zunehmend Bedeutung. Während bei der herkömmlichen Elektroinstallation jede Funktion eine eigene Leitung und jedes Steuerungssystem ein separates Netz benötigt, lassen sich mit dem EIBus alle betriebstechnischen Funktionen und Abläufe über eine gemeinsame Leitung erfassen, schalten, steuern, überwachen und melden. Die Energiezuleitung wird ohne Umwege zum Verbraucher geführt. Dabei werden Leitungen eingespart; darüber hinaus läßt sich die Gebäudeinstallation wesentlich einfacher realisieren, später problemlos erweitern und flexibel nutzen.

Der EIBus besteht aus einer zweiadrigen Leitung und busfähigen Installationsgeräten für den Verteilereinbau, für die Aufputz- und Unterputzmontage und für den Einbau in Aktoren, d. h. Verbraucher wie Leuchten, Jalousieantriebe und Heizgeräte. Sensoren, nämlich Lichttaster, Helligkeits- und Temperaturfühler, Windmesser usw. und Aktoren kommunizieren ohne Zentrale miteinander.

Herzstück der herkömmlichen EIB-Installation ist ein zentral angeordneter Verteiler mit EIB-Basisgeräten, Systemgeräten und Anwendungsgeräten. Er wird je nach Anforderung mit EIB-Modulen bestückt. Diese EIB-Module besitzen genormte Abmessungen und werden auf die handelsüblichen Hut-Schienen (DIN EN 50022) aufgerastet, wobei gleichzeitig der vorverdrahtete Bus kontaktiert wird.

Die busfähigen Unterputz-, Aufputz- und Einbaugeräte werden jeweils dort im Gebäude installiert, wo sie ihre Aufgabe erfüllen müssen. Jedes Bus-Gerät besteht prinzipiell aus einem universellen Bus-Ankoppler und einem aufgabenspezifischen Endgerät. Der Bus-Ankoppler wird durch Parametrierung auf das Endgerät eingestellt und kann bis zu vier Funktionen verwalten. Eingangs- und Ausgangskanäle können beliebig kombiniert werden. Bei Unterputzgeräten werden Bus-Ankoppler und Endgerät getrennt geliefert; die Endgeräte, üblicherweise Tastschalter, Temperaturfühler und dergleichen, werden einfach aufgesteckt.

Nachdem Verteiler, Bus-Geräte, Bus-Leitungen, Bus-Ankoppler, aufgabenspezifische Endgeräte, Energieleitungen, Aktoren und Sensoren montiert sind, muß das gesamte Installationssystem programmiert und auf einwandfreie Funktion überprüft werden. Stellt der Installateur nun fest, daß beim Druck auf einen beispielsweise als Lichtschalter vorgesehenen Sensor der zugehörige Aktor nicht funktioniert, d. h. die Glühlampe nicht leuchtet, wird er unter Verwendung seiner Testgeräte alle Hard- und Softwarefunktionen durchtesten, um schließlich festzustellen, daß nur die Glühlampe schadhaft war.

Hier setzt nun die vorliegende Erfindung ein, die sich die Aufgabe gestellt hat, die bestehenden EIB-Module, gleichgültig ob es sich dabei um Eingänge zum Anschluß von Sensoren oder um Ausgänge zum Anschluß von Aktoren handelt, derart weiterzubilden, daß sofort und ohne jegliche Hilfsmittel getestet werden kann, ob die Fehlfunktion auf einem Fehler im Bus-System oder einem Fehler im Energie-System beruht.

Diese Aufgabe wird gelöst durch ein EIB-Modul mit den Merkmalen des Anspruchs 1, wenn es sich um einen Ausgangskanal handelt, und durch ein EIB-Modul mit den Merkmalen des Anspruchs 2, wenn es sich um einen Eingangskanal handelt.

Dank der Signaldiode kann der Installateur erkennen, ob das Sensorsignal des an seinen Eingangskanal angeschalteten Sensors oder das Bus-Signal des seinen Aktor steuernden EIBuses anliegen. Gleichzeitig kann er mit Hilfe des Tasters das entsprechende Signal simulieren. Auf diese Weise kann der Installateur seine starkstromseitige Installation auch schon auf Funktion testen, bevor der EIBus programmiert ist, und er kann diese Tests bequem "vor Ort" vornehmen, nicht nur vom zentral angeordneten Verteiler aus, wo sich die separate Schnittstelle für sein mikroprozessorgesteuertes Testgerät befindet.

Dank des logischen Schalters mit zwei Eingängen und einem Ausgang erscheint am Ausgang das Aktor-Simulationssignal, sobald der Testtaster betätigt wird. Handelt es sich dagegen um einen Eingangskanal, erscheint am Ausgang das Sensor-Simulationssignal, sobald an einem Ausgangskanal der Testtaster betätigt wird.

Vorzugsweise ist die Innenbeschaltung des logischen Schalters derart, daß die an dem einen Eingang liegenden Signale, d. h. das Bus-Schaltsignal bzw. das Sensoreingangssignal, logischen Vorrang haben vor dem Testsignal.

Anhand der Zeichnung soll die Erfindung in Form von Ausführungsbeispielen näher erläutert werden. Es zeigen
- Fig. 1: eine Draufsicht auf einen Elektroinstallationskanal mit eingebautem EIB-Modul,
- Fig. 2: das Blockschaltbild eines elektronischen Schalters für einen EIB-Modul,

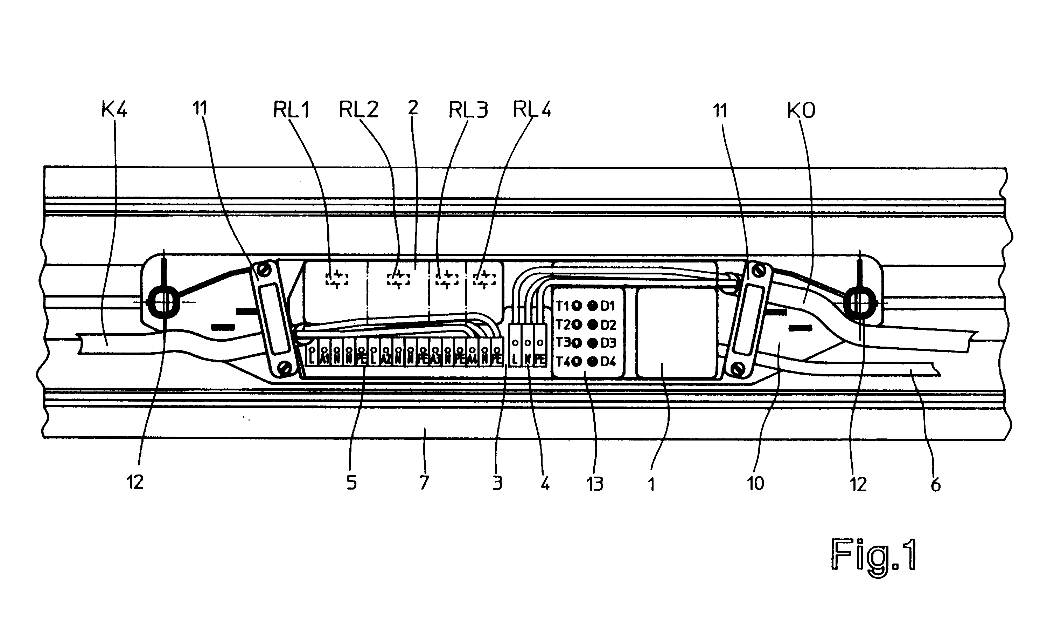

Fig. 1 zeigt eine Draufsicht auf einen Elektroinstallationskanal 7 mit abgenommenem Deckel. Eine EIBus-Leitung 6 ist mit einem Busankoppler 1 verbunden. An der Kanalrückwand ist das Unterteil 10 eines Montageelements zum lösbaren Befestigen von Installationsgeräten befestigt.

Das eigentliche EIB-Modul besteht aus einem universellen, programmierbaren Bus-Ankoppler 1 und einem zugehörigen Endgerät 2, hier in Form von vier Ausgangskanälen mit Schaltkontakten, jeweils aktiviert über ein Relais RL1, RL2, RL3, RL4. Bus-Ankoppler 1 und Endgerät 2 sitzen auf einer gedruckten Schaltungsplatine 3, die ihrerseits auf dem Unterteil 10 des Montageelements befestigt ist.

Auf der gedruckten Schaltungsplatine 3 sind darüber hinaus ein dreipoliger Klemmenblock 4 und ein vielpoliger Klemmenblock 5 befestigt. Der dreipolige Klemmenblock 4 dient zum Anschluß einer handelsüblichen Stromversorgungsleitung K0. An den vielpoligen Klemmenblock 5 können handelsübliche Stromverbindungsleitungen angeschlossen werden, wobei der Übersichtlichkeit halber nur die zum Ausgangskanal 4 gehörende Leitung K4 zeichnerisch dargestellt ist. Die gleichnamigen Pole L, N, PE der beiden Klemmenblöcke 4, 5 sind über gedruckte Leiterbahnen auf der Platine 3 verdrahtet. Die Ausgangsklemmen A1, A2, A3, A4 sind mit je einem relaisgesteuerten Schaltkontakt verbunden. Zugentlastungen 11 fixieren die Leitungen K0, K4.

Ein Testfeld 13 neben Bus-Ankoppler 1 zeigt zwei für den Installateur sehr nützliche Einrichtungen in Form je einer Signaldiode D1, D2, D3, D4 und je eines Testtasters T1, T2, T3, T4 für jeden der vier Ausgangskanäle. Die Signaldioden D1 ... D4 leuchten auf, wenn ein für den jeweiligen Kanal bestimmtes Bus-Schaltsignal erkannt wird. Auf diese Weise kann der Installateur sofort erkennen, wo bei einer Fehlfunktion der Fehler zu suchen ist.

Durch Druck auf einen der Testtaster T1 ... T4 kann der Installateur darüber hinaus das zugehörige Relais RL1 ... RL4 zum Anzug bringen, worauf der an den entsprechenden Klemmenblock angeschlossene Aktor aktiviert wird. Dieser Test kann auch schon vorgenommen werden, wenn der EIBus 6 und Bus-Ankoppler 1 noch nicht programmiert sind, so daß eine Verbindungsverdrahtung schon vorab auf Funktionsfähigkeit geprüft werden kann. Des weiteren hat der Installateur so die Möglichkeit, bei einer Aktor-Fehlfunktion mit Sicherheit zu unterscheiden, ob der für die Fehlfunktion verantwortliche Fehler auf der Bus-Seite oder auf der Seite der Verbindungsverdrahtung zu suchen ist.

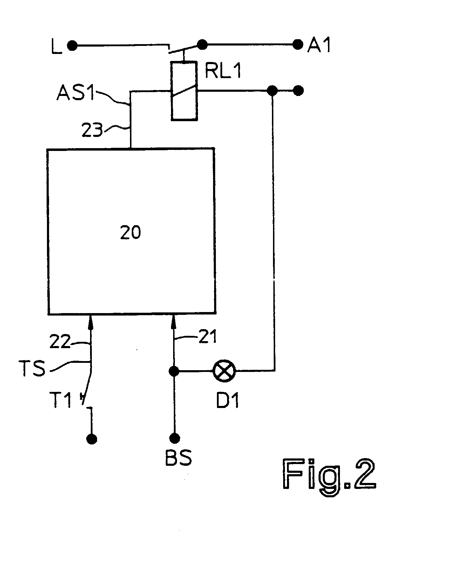

Fig. 2 zeigt in Form eines Blockschaltbildes die Zusatzelektronik im Inneren des Endgerätes 2, die benötigt wird, um die Signaldioden D1 ... D4 und Testtaster T1 ... T4 so zu integrieren, daß die Bus-Ankopplung 1 nicht gestört wird. Prinzipiell handelt es sich um einen elektronischen Schalter 20, an dessen einem Eingang 21 das Bus-Steuersignal BS und an dessen anderem Eingang 22 das Testsignal TS, ausgelöst beim Druck auf den Testtaster T1, anliegen. Am Ausgang 23 erscheint dann das Aktor-Simulationssignal AS1, welches das Relais RL1 zum Anziehen bringt, worauf an der Aktorklemme A1 beispielsweise eine 230 V Wechselspannung anliegt.

Der Schalter 20 ist ein ODER-Gatter, wobei jedoch durch die interne Verschaltung dafür gesorgt ist, daß das am Eingang 21 anliegende Bus-Steuersignal BS Vorrang hat vor dem Testsignal TS.

## Patentansprüche

1. EIB-Modul, bestehend aus einem universellen Busankoppler (1) und einem aufgabenspezifischen Endgerät (2) mit wenigstens einem Ausgangskanal (A1, A2, A3, A4), gekennzeichnet durch folgende Merkmale:
- jedem Kanal (A1 ... A4) ist eine Signaldiode (D1 ... D4) und ein Testtaster (T1 ... T4) zugeordnet,
-- wobei die Signaldiode (D1 ... D4) das Schaltsignal des EIBus (6) anzeigt und der Testtaster (T1 ... T4) ein Aktor Aktor-Simulationssignal (AS1 ... AS4) auf den zugehörigen Aktor (Ar1 ... Ar4) gibt,
- es ist ein logischer Schalter (20) mit zwei Eingängen (21, 22) und einem Ausgang (23) vorgesehen,
-- am einen Eingang (21) liegt das Bus-Schaltsignal (BS) an,
-- am anderen Eingang (22) liegt das Testsignal (TS) an,
- am Ausgang (23) erscheint das Aktor-Simulationssignal (AS1).

2. EIB-Modul, bestehend aus einem universellen Busankoppler (1) und einem aufgabenspezifischen Endgerät (2) mit wenigstens einem Eingangskanal gekennzeichnet durch folgende Merkmale:
- jedem Kanal ist eine Signaldiode und ein Testtaster zugeordnet,
-- wobei die Signaldiode das Schaltsignal eines angeschlossenen Sensors anzeigt und der Testtaster ein Sensor-Simulationssignal auf den EIBus gibt,
- es ist ein logischer Schalter mit zwei Eingängen und einem Ausgang vorgesehen,
-- am einen Eingang liegt das Sensoreingangssignal an,
-- am anderen Eingang liegt das Testsignal an,
- am Ausgang erscheint das Sensor-Simulationssignal.

3. EIB-Modul nach Anspruch 1 oder 2, gekennzeichnet durch das Merkmal:
- die am einen Eingang liegenden Signale haben Vorrang vor dem Testsignal.

## Claims

1. An EIB module, comprising a universal bus coupler (1) and a function-specific terminal device (2) with at least one output channel (A1,A2,A3,A4), characterised by the following features:
- each channel (A1 ... A4) is associated with a signal diode (D1 ... D4) and a test button (T1 ... T4),
-- wherein the signal diode (D1 ... D4) indicates the switching signal of the EIBus (6) and the test button (T1 ... T4) emits an actuator simulation signal (AS1 ... AS4) to the associated actuator (Ar1 ... Ar4),
-- a logic switch (20) is provided with two inputs (21,22) and one output (23),
-- the bus switching signal (BS) is applied to one input (21),
-- the test signal (TS) is applied to the other input (22),
-- the actuator simulation signal (AS1) appears at the output (23).

2. An EIB module, comprising a universal bus coupler (1) and a function-specific terminal device (2) with at least one input channel, characterised by the following features:
- each channel is associated with a signal diode and a test button,
-- wherein the signal diode indicates the switching signal of a connected sensor and the test button emits a sensor simulation signal to the EIBus,
-- a logic switch is provided with two inputs and one output,
-- the sensor input signal is applied to one input,
-- the test signal is applied to the other input,
-- the sensor simulation signal (AS1) appears at the output.

3. An EIB module according to Claim 1 or 2,
characterised by the feature:
- the signals applied to one input have precedence over the test signal.

## Revendications

1. Module EIB (European Installation Bus) constitué d'un coupleur de bus universel (1) et d'un terminal (2) destiné à une tâche spécifique caractérisé en ce qu'il comporte au moins un canal de sortie (A1, A2, A3, A4), en ce qu'une diode de signal (D1 ... D4) et un bouton test (T1 ...T4) sont affectés à chaque canal (A1 .... A4), en ce que la diode de signal (D1 ... D4) indique le signal de commutation du bus (6), et le bouton test (T1 ... T4) donne un signal de simulation d'acteur (AS1 ... AS4) sur l'acteur afférent (Ar1 ... Ar4), en ce qu'un commutateur logique (20) présente deux entrées (21, 22) et une sortie (23), en ce que le signal de commutation du bus (BS) est associé à l'une des entrées (21), que le signal de test (TS) est associé à l'autre entrée (22), et que le signal de simulation d'acteur (AS1) apparaît à la sortie (23).

2. Module EIB, constitué d'un coupleur de bus universel (1) et d'un terminal (2) destiné à une tâche spécifique **caractérisé en ce qu'il**
comporte au moins un canal d'entrée, en ce qu'une diode de signal et un bouton test sont affectés à chaque canal, en ce que la diode de signal indique le signal de commutation d'un capteur relié, et le bouton test donne un signal de simulation du capteur sur le bus EI, en ce qu'un commutateur logique présente deux entrées et une sortie, en ce que le signal d'entrée du capteur est associé à l'une des entrées, que le signal de test est associé à l'autre entrée, et que le signal de simulation de capteur apparaît à la sortie.

3. Module EIB selon la revendication 1 ou la revendication 2, caractérisé en ce que les signaux associés à une entrée ont la priorité devant le signal de test.
